# NOUVEAU FASCICULE DE BREVET EUROPEEN

(11) **EP 0 879 897 B2**
(45) Date de publication et mention de la décision concernant l'opposition: **02.08.2006**
(45) Mention de la délivrance du brevet: 02.07.2003
(21) Numéro de dépôt: 98870028.2
(22) Date de dépôt: 11.02.1998
(51) Int. Cl.: C21D 1/38, C21D 9/56, C23C 14/02, C21D 1/773

(54) **Procédé de recuit d'un substrat métallique au défilé**
Verfahren zum Durchlaufglühen von Metallsubstraten
Process for continuous annealing of metal substrates

(30) Priorité: 11.02.1997 BE 9700125
(43) Date de publication de la demande: 25.11.1998
(73) Titulaire: ARCELOR France, 93200 St Denis (FR)
(72) Inventeur: Vanden Brande, Pierre, 1040 Bruxelles (BE); Weymeersch, Alain, 1300 Wavre (BE); Harlet, Philippe, 6000 Charleroi (Ransart) (BE)
(74) Mandataire: Claeys, Pierre

(56) Documents cités:
- EP-A- 0 397 952
- EP-A- 0 461 011
- EP-A- 0 535 568
- EP-A- 0 560 526
- DD-A- 120 474
- DE-A- 3 723 865
- JP-A- 6 279 843
- LU-A- 87 547
- US-A- 3 146 336
- US-A- 4 863 756
- US-A- 4 896 813
- PATENT ABSTRACTS OF JAPAN vol. 2, no. 85 (C-017), 12 juillet 1978 & JP 53 045612 A (KOBE STEEL LTD), 24 avril 1978,
- PATENT ABSTRACTS OF JAPAN vol. 95, no. 4, 31 mai 1995 & JP 07 018465 A (KAWASAKI STEEL CORP.), 20 janvier 1995,
- PATENT ABSTRACTS OF JAPAN vol. 95, no. 1, 28 février 1995 & JP 06 279843 A (NIPPON STEEL CORP.), 4 octobre 1994,
- S. Schiller, U. Heisig et K. Steinfelder, "A New Sputter Cleaning System for Metallic Substrates", Thin Solid Films, 33(1976), 331-339
- S. Schiller, U. Heisig et K. Goedicke, "On the use of ring gap discharges for high-rate vacuum coating", J. Vac. Sci. Technol., Vol. 14, No. 3,Mai/Juin 1977, 815-818
- E. Darrel Erikson, "Thickness distribution of a metal-alloy from a high-rate electron-beam source", J. Vac. Sci. Technol., Vol. 11, No. 1, Jan/ Fév. 1974, 366-370
- Leon I. Maissel et Reinhard Glang, Handbook of Thin Film Technology,McGraw-Hill Book Company (1983), ISBN 0-07-039742-2, pages 4-34
- Grand Dictionnaire encyclopédique Larousse, page 8782
- P. Auger, M.D. Grmek, Encyclopédie Internationale, Edit. R.G. Morvan, page 559

## Description

La présente invention est relative à un procédé de recuit continu d'un substrat métallique au défilé, notamment d'une tôle d'acier.

Les techniques de recuit en continu appliquées actuellement suivant lesquelles les substrats à traiter sont soumis à des températures relativement élevées présentent différents inconvénients.

Ainsi, l'inertie thermique des installations pour la mise en oeuvre de ces procédés connus est très importante. La consommation en gaz réducteur nécessaire pour éviter l'oxydation des substrats est élevée. Il est impossible d'obtenir, par une seule opération de recuit, un état de surface qui soit tel à permettre le dépôt d'une couche ultérieure, de sorte qu'en général une étape supplémentaire de décapage est nécessaire. Etant donné que dans les installations de recuit connues on fait usage de tubes radiants comme moyens de chauffage, ces installations sont d'une taille importante et provoquent, de plus, des coûts d'entretien élevés. Pour le recuit de substrats ferromagnétiques, lorsqu'on fait usage d'un chauffage par induction à moyenne fréquence, on est limité à des températures en dessous de la température de Curie, Enfin, le système de chauffage en moyenne et haute fréquences présente un mauvais rendement énergétique.

On connaît par ailleurs un procédé de traitement d'un substrat en acier au défilé présentant une largeur, notamment d'une tôle d'acier, comprenant
- une création, dans une atmosphère gazeuse dans laquelle défile le substrat, d'un plasma froid qui est réparti sur toute la largeur du substrat, avec formation de décharges par plasma entre une première face du substrat, qui forme une électrode, et une contre-électrode,
- une dissipation de puissance électrique provenant de ces décharges dans le substrat, et
une distribution uniforme de densité de puissance provenant de ces décharges sur toute la largeur du substrat (voir par exemple US-A-4896813; S. Schiller et coll., A new sputter cleaning system for metallic substrates, in Thin Solid Films, 33(1976), 331-339; S. Schiller et coll., The use of ring gape discharges for high-rate vacuum ring, in J. Vac. Sci. Technol., Vol. 14, n°3, mai/juin 1977).
On connaît aussi un procédé de balayage de substrat par des plasmas chauds (v. Patent Abstracts of Japan, vol. 95, n°4, 31 mai 1995 et JP 07018465 A).

Un des buts essentiels de la présente invention consiste à proposer un procédé qui permet de remédier aux inconvénients précités et qui, de plus, permet d'associer, à une étape de recristallisation à haute vitesse et à température appropriée, une préparation de la surface, de sorte que celle-ci permet le dépôt d'une couche ultérieure de finition sans qu'il soit nécessaire de soumettre cette surface à une opération supplémentaire de décapage, par exemple.

A cet effet, suivant l'invention, on prévoit un procédé de traitement d'un substrat en acier au moyen de décharges par plasma, tel qu'indiqué ci-dessus, procédé qui comprend un recuit de recristallisation uniforme du substrat en défilement au moyen desdites décharges par plasma.

Avantageusement, ce recuit est effectué à une pression comprise entre 10⁻⁴ et 100 Torr.

Suivant une forme de réalisation préférentielle, on réalise le recuit soit en atmosphère réductrice, par exemple en présence d'hydrogène, de méthane, d'un mélange azote-hydrogène ou encore d'un mélange argon-hydrogène, soit en atmosphère oxydante suivie d'une atmosphère réductrice.

Suivant une autre forme de réalisation préférentielle du procédé selon l'invention, on fait usage d'une décharge de type magnétron, le substrat étant à la cathode et la pression des gaz pendant le recuit étant comprise entre 0,001 Torr et 1 Torr.

D'autres formes de réalisation de l'invention sont indiquées dans les revendications annexées.

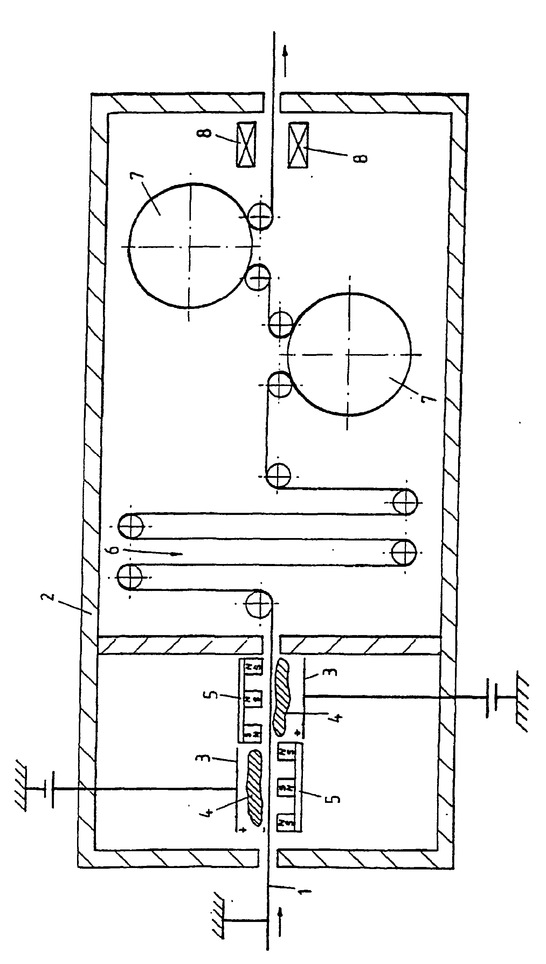

D'autres détails et particularités de l'invention ressortiront de la description, donnée ci-après, à titre d'exemple non limitatif, d'une forme de réalisation particulière du procédé suivant l'invention avec référence à la figure unique annexée, qui est une représentation schématique d'une installation pour la mise en oeuvre du procédé suivant l'invention.

Dans la description donnée ci-après, les chiffres de référence se rapportent à cène figure.

L'invention concerne, d'une façon générale, un procédé de recuit d'un substrat métallique au défilé qui est de préférence constitué d'une tôle d'acier 1 se déplaçant d'une manière sensiblement continue à travers une chambre de recuit 2 dans laquelle on réalise le recuit au moyen de décharges par plasma.

Cette chambre 2 est constituée d'une enceinte fermée dans laquelle règne une pression qui est généralement comprise entre 10⁻⁴ et 100 Torr, de préférence inférieure à 10 Torr.

Les décharges sont établies entre la tôle 1, lors de son passage à travers cette chambre 2, et une contre-électrode 3, d'une manière telle à dissiper la puissance électrique provenant des décharges dans cette tôle 1 et ainsi donc à créer le recuit. On obtient ainsi une recristallisation à haute vitesse, ce qui permet d'obtenir des grains relativement fins, par exemple, pour la production d'acier de haute résistance.

Il s'agit donc en fait d'un procédé de pulvérisation cathodique ("sputtering") au cours duquel la tôle est bombardée par des ions en provenance d'un plasma 4 permettant un chauffage rapide et uniforme et, en même temps, un décapage de la surface de celle-ci.

Suivant l'invention, le plasma peut être créé en courantcontinu, la tôle formant alors la cathode, ou en courant altematif.

Dans ce dernier cas, on fait usage d'une contre-électrode 3 s'étendant dans la chambre de recuit 2, en regard de la tôle 1, et présentant une surface dirigée vers la tôle dont la superficie est supérieure à celle de la partie de la tôle lui faisant face, afin de maintenir une auto-polarisation négative de cette dernière.

Comme dans le procédé classique de pulvérisation cathodique, la décharge peut éventuellement être réalisée en présence de champs d'induction magnétiques grâce à la présence d'aimants 5 à proximité de la tôle 1 et du côté opposé de celle-ci par rapport à la contre-électrode 3.

Les densités de puissance dissipées par face sur la tôle d'acier 1 sont typiquement comprises entre 1 W/cm² et 500 W/cm², alors que les vitesses de défilement de cette tôle sont généralement comprises entre 1 m/min et 1500 m/min.

La montée en température a lieu dans la zone de la tôle où se fait la dissipation de puissance, tandis que la vitesse de montée en température dépend de l'adaptation de la densité de puissance utilisée, de la vitesse de ligne ainsi que de répaisseur de la tôle et de sa capacité calorifique.

Dans certains cas, il peut être utile d'introduire un palier de stabilisation en température dans le cycle de recuit. Ceci peut, par exemple, être obtenu en prévoyant dans la chambre de recuit2 une zone où la tôle défile librement sous une pression réduite. Il suffit, par exemple, dans un tel cas, de prévoir un compartiment 6 quelque peu isolé de celui où a lieu la création du plasma. A cet égard, il y a lieu de noter qu'à pression réduite, les pertes thermiques par conduction sont limitées et les pertes par radiation peuvent être restituées à la tôle au moyen de réflecteurs ou par des moyens de chauffage d'appoint radiants.

Dans d'autres cas encore, il peut être utile de refroidir la tôle 1 dans la chambre de recuit 2, donc sous pression réduite, par exemple en faisant passer la tôle sur des cylindres de refroidissement 7. Ainsi, toujours dans la chambre de recuit 2, on peut encore, si nécessaire, envisager de revêtir la tôle 1 par un film de finition ou de protection, par exemple, par un procédé de dépôt PVD ("physical vapor déposition), PECVD ("plasma enhanced chemical vapor déposition'') ou encore par un procédé CVD ("Chemical vapor deposition") à raide d'un dispositif de dépôt sous vide a.

La tôle ainsi traitée peut quitter la chambre de recuit 2 à une température compatible avec la fin du procédé métallurgique.

Signalons encore que le recuit peut être réalisé en atmosphère réductrice, par exemple en présence d'hydrogène, de méthane, d'un mélange azote-hydrogène ou encore d'un mélange argon-hydrogène. Si nécessaire, un prénettoyage plasma peut être effectué en atmosphère oxydante, par exemple pour éliminer des huiles présentes après une étape de laminage. Cette atmosphère oxydante peut être formée d'un mélange d'argon-oxygène contanant éventuellement du CF₄ et pourrait être suivie d'une atmosphère réductrice

Ci-après sont donnés quelques exemples de réalisation pratiques permettant d'illustrer davantage le procédé suivant l'invention.

### Exemple 1 : Traitement d'une tôle d'acier laminée à froid non revêtue au défilé

| | |
|---|---|
| Vitesse de ligne | 200 m/min |
| Largeur de bande | 1000 mm |
| Epaisseur de bande | 1 mm |
| Température d'entrée de recuit | 20°C |
| Température max. de recuit (plateau) | 700°C |
| Temps de maintien | 30s |
| Vitesse de refroidissement (jusqu'à 20°C) | 50°C/s |

Dans ces conditions, la zone de montée en température était limitée à 10 m de long pour une puissance utile de 10 MW, créant ainsi une vitesse de montée en température de l'ordre de 224°C/s. La zone de maintien en température nécessitait une longueur utile de 100m. Le tôle était disposée en accordéon, ce qui permettait une minimisation des pertes thermiques. Par ailleurs, on a fait usage de cylindres de refroidissement de longueur développée utile de l'ordre de 2.5 m, de sorte qu'il a fallu 20 cylindres pour revenir à la température ambiante. Après le sas de sortie, la tôle a été enroulée sous forme de bobine.

### Exemple 2 : Traitement d'une tôle de fer blanc

| | |
|---|---|
| Vitesse de ligne | 800m/min |
| Largeur de bande | 1000 mm |
| Epaisseur de bande | 0.18 mm |
| Température d'entrée de recuit | 20°C |
| Température max. de recuit (pas de maintien) | 600°C |
| Vitesse de refroidissement (jusqu'à 20°C) | 6°C/s |

Dans cas conditions la zone de montée en température a été limitée à 7 m de long pour une puissance utile de 10 MW, créant ainsi une vitesse de montée en température de l'ordre de 1200°C/s. La tôle a subi un refroidissement de 600°C à 420°C à une vitesse de 6°C/s, ce qui a nécessité un refroidissement de 400 m. Le refroidissement a été assuré par Jet cooling après le sas de sortie sous atmosphère contrôlée. Ensuite, la tôle a été étamée ou passivée.

### Exemple 3 : Traitement d'une tôle pour galvanisation au trempé

| | |
|---|---|
| Vitesse de ligne | 140 m/min |
| Largeur de bande | 1000 mm |
| Epaisseur de bande | 1 mm |
| Température d'entrée de recuit | 20°C |
| Température max. de recuit (plateau) | 800°C |
| Temps de maintien | 20s |
| Vitesse de refroidissement (jusqu'à 500°C) | 100°C/s |

Dans ces conditions, la zone de montée en température a été limitée à 7 m de long pour une puissance utile de 10 MW, créant ainsi une vitesse de montée en température de l'ordre de 260°C/s. La zone de maintien en température nécessitait une longueur utile de 47 m. Aussi, la tôle a été disposée en accordéon pour permettre la minimisation des pertes thermiques. La tôle a subi un refroidissement de 800°C à 500°C à une vitesse de 100°C/s, ce qui a nécessité une longueur utile de refroidissement de 7 m sur des cylindres de refroidissement (3 cylindres de 2,5 m de longueur utile développée). Après la sortie de l'installation via le sas, la tôle a été plongée dans un bain de zinc liquide à 490°C, essorée et refroidie.

Une alternative consistait à refroidir la tôle jusqu'à 100°C, ce qui a nécessité 3 cylindres de refroidissement supplémentaires, et à la revêtir immédiatement d'un film de protection ou de finition sans revenir à la pression atmosphérique par évaporation sous vide (par exemple par sputter-évaporation). Après le sas de sortie, la tôle a été SKIN passée, huilée et enroulée.

Il est bien entendu que l'invention n'est pas limités aux formes de réalisation décrites ci-dessus et que bien des variantes peuvent être envisagées sans sortir du cadre de la présente invention, notamment en ce qui concerne la création du plasma de recuit, le confinement magnétron qui. à pression relativement élevée, pourrait être omis, la cathode, qui peut être une cathode creuse formée par la tôle se déplaçant en zig-zag ou en accordéon.

Une des différences importantes de l'invention par rapport à l'état antérieur de la technique réside dans le type de plasma utilisé pour chauffer la bande métallique à traiter. En effet, dans le procédé suivant l'invention on fait usage de ce qui est communément appelé "plasmas froids" uniformément répartis sur toute la largeur de la bande métallique alors que dans les procédés connus on fait usage soit de plasmas d'arcs caractérisés par des points chauds localisés à la surface de la bande métallique soit des jets de plasma chaud également à action très locale au niveau de la surface à traiter. Cette action très localisée implique donc nécessairement des systèmes de déplacement rapides des points chauds relativement au substrat, c'est-à-dire des systèmes permettant le déplacement des arcs ou des jets de plasma par des moyens indépendants du déplacement de la bande métallique. Ce déplacement des points chauds est généralement indispensable afin de tendre vers une densité de puissance moyenne dissipée par unité de surface constante sur la largeur de la tôle. Un tel problème ne se pose pas par le procédé suivant l'invention étant donné que la densité de puissance dissipée à la tôle est uniformément répartie sur toute la largeur traitée de la bande métallique.

## Revendications

1. Procédé de traitement d'un substrat en acier au défilé présentant une largeur, notamment d'une tôle d'acier, comprenant
- une création, dans une atmosphère gazeuse dans laquelle défile le substrat, d'un plasma froid qui est réparti sur toute la largeur du substrat, avec formation de décharges par plasma entre une première face du substrat, qui forme une électrode, et une contre-électrode,
- une dissipation de puissance électrique provenant de ces décharges dans le substrat, et
- une distribution uniforme de densité de puissance provenant de ces décharges sur toute la largeur du substrat,
**caractérisé en ce qu'**il comprend un recuit de recristallisation uniforme du substrat en défilement au moyen desdites décharges par plasma.

2. Procédé suivant la revendication 1, **caractérisé en ce que** l'on effectue le recuit précité à une pression comprise entre 10⁻⁴ et 100 Torr, de préférence inférieure à 10 Torr.

3. Procédé suivant l'une des revendications 1 et 2, **caractérisé en ce que** l'on crée le plasma en courant continu, le substrat formant alors une cathode.

4. Procédé suivant l'une des revendication 1 et 2, **caractérisé en ce que** l'on crée le plasma en courant alternatif en faisant usage d'une contre-électrode s'étendant en regard du substrat et présentant, dans un volume déterminé, une surface dirigée vers le substrat, dont la superficie est supérieure à celle de la partie du substrat présente dans ce volume, afin de maintenir une auto-polarisation négative de cette dernière.

5. Procédé suivant l'une quelconque des revendications 1 à 5, **caractérisé en ce que** l'on réalise les décharges en présence de champs d'induction magnétiques.

6. Procédé suivant l'une quelconque des revendications 1 à 5, **caractérisé en ce que** l'on réalisé le recuit soit en atmosphère réductrice, par exemple en présence d'hydrogène, de méthane, d'un mélange azote-hydrogène ou encore d'un mélange argon-hydrogène, soit en atmosphère oxydante suivie d'une atmosphère réductrice.

7. Procédé suivant l'une quelconque des revendications 1 à 6, **caractérisé en ce que** l'on fait défiler le substrat à une vitesse comprise entre 1 m/min et 1500 m/min.

8. Procédé suivant l'une quelconque des revendications 1 à 7, **caractérisé en ce que** l'on fait usage d'une décharge de type magnétron, le substrat étant à la cathode et la pression étant comprise entre 0,001 et 1 Torr.

9. Procédé suivant l'une quelconque des revendications 5 à 8, **caractérisé en ce qu'il** comprend, pour former les champs d'induction magnétiques, un agencement d'aimants à proximité du substrat, d'un côté de celui-ci qui est à l'opposé de la contre-électrode.

10. Procédé suivant l'une quelconque des revendications 1 à 9, **caractérisé en ce qu'**il comprend
- une création d'un plasma froid additionnel au moyen de décharges par plasma entre une deuxième face du substrat et une contre-électrode additionnelle, ledit plasma additionnel étant réparti sur toute la largeur du substrat, et
- une dissipation de puissance électrique provenant de ces décharges dans le substrat avec une distribution uniforme de densité de puissance sur toute sa largeur et un recuit de recristallisation uniforme de celui-ci.

11. Procédé suivant l'une quelconque des revendications 1 à 10 **caractérisé en ce qu'**il comprend en outre un refroidissement du substrat recuit, suivi d'un revêtement du substrat recuit, refroidi, par un film de finition ou de protection.

## Claims

1. A process for treating a metal substrate running past having a width, especially a steel sheet, comprising :
- creating, in a gaseous atmosphere wherein the substrate runs past, a cold plasma which is spread over the entire width of the substrate, with formation of plasma discharges between a first side of the substrate, which forms an electrode, and a counter electrode,
- dissipating electrical power from said discharges into the substrate, and
- uniformly distributing a power density from said discharges over the entire width of the substrate,
**characterized in that** the process comprises a uniform recrystallisation annealing of the substrate running past by means of said plasma discharges.

2. A process according to claim 1, **characterized in that** the annealing is performed at a pressure comprised between 10⁻⁴ and 100 Torr, and preferably at a pressure lower than 10 Torr.

3. A process according to anyone of claims 1 and 2, **characterized in that** the plasma is created with direct current, the substrate forming thus a cathode.

4. A process according to anyone of claims 1 and 2, **characterized in that** the plasma is created with alternating current by making use of a counter electrode extending opposite the substrate and showing, in a determined volume, a surface directed towards the substrate, the surface area of which is larger than the one of the portion of the substrate present in this volume in order to maintain a negative autopolarisation of this substrate.

5. A process according to anyone of claims 1 to 4, **characterized in that** the discharges are realised in the presence of magnetic induction fields.

6. A process according to anyone of claims 1 to 5, **characterized in that** the annealing is realised in a reducing atmosphere, for example in the presence of hydrogen, methane, a nitrogen-hydrogen mixture or further an argon-hydrogen mixture, or in an oxidising atmosphere followed by a reducing atmosphere.

7. A process according to anyone of claims 1 to 6, **characterized in that** the substrate is caused to run at a speed comprised between 1 m/min and 1500 m/min.

8. A process according to anyone of claims 1 to 7, **characterized in that** use is made of a discharge of the magnetron type, the substrate being at the cathode and the pressure being comprised between 0.001 and 1 Torr.

9. A process according to anyone of claims 5 to 8, **characterized in that**, for forming the magnetic induction fields, the process comprises an arrangement of magnets near the substrate, on the side thereof which is opposite with respect to the counter electrode.

10. A process according to anyone of the claims 1 to 9, **characterized in that** it comprises :
- creating an additional cold plasma by means of plasma discharges between a second side of the substrate and an additional counter electrode, said additional plasma being spread over the entire width of the substrate, and
- dissipating electrical power from said discharges into the substrate, with uniform distribution of a power density over the entire width thereof and a uniform recrystallisation annealing thereof.

11. A process according to anyone of claims 1 to 10, **characterized in that** it further comprises cooling down the annealed substrate, followed by a coating of the cooled annealed substrate with a finishing or protective film.

## Patentansprüche

1. Verfahren zum Durchlaufbehandeln eines Substrats aus Stahl, das eine Breite aufweist, insbesondere eines Stahlblechs, umfassend
- eine Bildung, in einer Gasatmosphäre, in welcher das Substrat durchläuft, eines kalten Plasmas, das über die gesamte Breite des Substrats verteilt ist, unter Bildung von Plasmaentladungen zwischen einer ersten Fläche des Substrats, welche eine Elektrode bildet, und einer Gegenelektrode,
- eine Dissipation von elektrischer Leistung, die von diesen Entladungen herrührt, in dem Substrat, und
- eine gleichförmige Verteilung der Leistungsdichte, die von diesen Entladungen herrührt, über die gesamte Breite des Substrats,
**dadurch gekennzeichnet, dass** das Verfahren ein gleichförmiges Rekristallationsglühen des Substrats beim Durchlaufen mittels der Plasmaentladungen umfasst.

2. Verfahren nach Anspruch 1, **dadurch gekennzeichnet, dass** das vorstehend genannte Glühen bei einem Druck zwischen 10⁻⁴ und 100 Torr, vorzugsweise unterhalb von 10 Torr, durchgeführt wird.

3. Verfahren nach einem der Ansprüche 1 oder 2, **dadurch gekennzeichnet, dass** das Plasma mit Gleichstrom erzeugt wird, wobei das Substrat dann eine Kathode bildet.

4. Verfahren nach einem der Ansprüche 1 oder 2, **dadurch gekennzeichnet, dass** das Plasma mit Wechselstrom erzeugt wird, indem eine Gegenelektrode verwendet wird, die sich gegenüber dem Substrat erstreckt und, in einem bestimmten Volumen, eine gegen das Substrat gerichtete Oberfläche aufweist, deren Flächeninhalt größer ist als derjenige des in diesem Volumen anwesenden Teils des Substrats, um eine negative Autopolarisation dieses letzteren zu erhalten.

5. Verfahren nach einem der Ansprüche 1 bis 4, **dadurch gekennzeichnet, dass** die Entladungen bei Anwesenheit von magnetischen Induktionsfeldern durchgeführt werden.

6. Verfahren nach einem der Ansprüche 1 bis 5, **dadurch gekennzeichnet, dass** das Glühen entweder in einer reduzierenden Atmosphäre, beispielsweise bei Anwesenheit von Wasserstoff, von Methan, eines Stickstoff-Wasserstoff-Gemischs oder auch eines Argon-Wasserstoff-Gemischs, oder in einer oxidierenden Atmosphäre, gefolgt von einer reduzierenden Atmosphäre, durchgeführt wird.

7. Verfahren nach einem der Ansprüche 1 bis 6, **dadurch gekennzeichnet, dass** man das Substrat mit einer Geschwindigkeit zwischen 1 m/min und 1.500 m/min durchlaufen lässt.

8. Verfahren nach einem der Ansprüche 1 bis 7, **dadurch gekennzeichnet, dass** eine Entladung vom Magnetron-Typ verwendet wird, wobei das Substrat an der Kathode ist und der Druck zwischen 0,001 und 1 Torr liegt.

9. Verfahren nach einem der Ansprüche 5 bis 8, **dadurch gekennzeichnet, dass** es zum Bilden der magnetischen Induktionsfelder eine Anordnung von Magneten in der Nähe des Substrats, auf einer Seite desselben, welche der Gegenelektrode entgegengesetzt ist, umfasst.

10. Verfahren nach einem der Ansprüche 1 bis 9, **dadurch gekennzeichnet, dass** es
- eine Erzeugung eines zusätzlichen kalten Plasmas mittels Plasmaentladungen zwischen einer zweiten Fläche des Substrats und einer zusätzlichen Gegenelektrode, wobei das zusätzliche Plasma über die gesamte Breite des Substrats verteilt ist, und
- eine Dissipation von elektrischer Leistung, die von diesen Entladungen herrührt, in dem Substrat mit einer gleichförmigen Verteilung der Leistungsdichte über seine ganze Breite und ein gleichförmiges Rekristallationsglühen desselben
umfasst.

11. Verfahren nach einem der Ansprüche 1 bis 10, **dadurch gekennzeichnet, dass** das Verfahren ferner ein Abkühlen des geglühten Substrats, gefolgt von einer Beschichtung des abgekühlten, geglühten Substrats mit einem End- oder Schutzfilm, umfasst.
